# EUROPEAN PATENT APPLICATION

(11) **EP 4 769 406 A1**
(43) Date of publication of application: **01.07.2026**
(21) Application number: 25184766.1
(22) Date of filing: 24.06.2025
(51) Int. Cl.: G11C 11/16, G11C 13/00

(54) **BIT CELL, IN-MEMORY COMPUTING CIRCUIT FOR MAJORITY FUNCTIONS, AND IN-MEMORY COMPUTING METHOD**

(30) Priority: 30.12.2024 US 202419004610
(71) Applicant: GlobalFoundries U.S. Inc., Malta, NY 12020 (US)
(72) Inventor: Narla, Siri, Malta, 12020 (US); Soss, Steven Robert, Malta, 12020 (US); Andre, Thomas W., Malta, 12020 (US)
(74) Representative: Grünecker Patent- und Rechtsanwälte PartG mbB

(57) **Abstract**

A bit cell (BC) includes: a variable resistor and a first transistor connected in series between two end nodes; and a second transistor also connected between the two end nodes. Gates of the first and second transistors are connected to first and second word lines (WLs), respectively, for a row. A circuit includes an array of BCs. In each column, BCs are connected in a stack between a sense amplifier (SA) and footer device (FD). During a read operation, FDs connect the stacks to ground. Additionally, first and second WL voltages on first and second WLs for each row are such that, for any selected row, first transistors of BCs are on and second transistors are off and, for any unselected row, first transistors of BCs are off and second transistors are on. SAs compare sense currents from the stacks to a mid-level reference current to concurrently compute majority functions.

## Description

### BACKGROUND

The present disclosure relates to in-memory computing and, more particularly, to embodiments of a bit cell, to embodiments of an in-memory computing circuit (including an array of these bit cells) for computing majority functions, and to embodiments of an associated in-memory computing method.

Historically, software solutions have been employed to compute complex functions (e.g., for artificial intelligence (AI) applications). Recently, specialized analog in-memory computing (AiMC) circuits have been developed for some of these complex functions (e.g., multiply-accumulate (MAC) functions). It could, however, be advantageous to have such specialized AiMC circuits for other complex functions.

For example, hyperdimensional computing (HDC) has emerged as an alternative to neural networks in AI applications. With HDC, vectors represent features (referred to herein as feature vectors) and are encoded together through, for example, a series of exclusive OR (XOR) and majority functions to create a hypervector. Generally, an XOR function compares two input and outputs a single output. The output is a logic value of 1 if the inputs are different and a logic value of 0 if the inputs are the same. A majority function refers to a function that outputs a logic value of 1 when more than half of multiple inputs have logic values of 1 and outputs a logic value of 0 when more than half of the inputs have logic values of 0. The hypervector can be employed for a classification look-up. Classification look-up refers to a machine learning (ML) method where a model is employed to predict the correct label for input data. Currently, software solutions are employed to solve these XOR and majority functions in HDC. Unfortunately, because each feature vector can be very long (e.g., upwards of 10,000 bits or more), executing the software (including vector retrieval, vector processing, and hypervector creation) can be process intensive and can consume a significant amount of power.

### SUMMARY

Disclosed herein are embodiments of a bit cell, an in-memory computing circuit for majority functions and an in-memory computing method for majority functions.

Embodiments of the bit cell can include a variable resistor and a first transistor, which are connected in series between a first end node and a second end node. A first gate of the first transistor can be connected to a first word line. The bit cell can also include a second transistor, which is connected between the first end node and the second end node. A second gate of the second transistor can be connected to a second word line.

Embodiments of the in-memory computing circuit can include an array of bit cells in columns and rows. The in-memory computing circuit can also include first word lines for the rows, respectively; and second word lines for the rows, respectively. Each bit cell can include a variable resistor and a first transistor, which are connected in series between a first end node and a second end node. A first gate of the first transistor can be connected to a first word line for a row. Each bit cell can also include a second transistor, which is connected between the first end node and the second end node. A second gate of the second transistor can be connected to a second word line for the row.

Embodiments of the in-memory computing method can include storing bit values in bit cells of an array of bit cells that are arranged in columns and rows. Each bit cell can include a variable resistor and a first transistor, which are connected in series between a first end node and a second end node. A first gate of the first transistor can be connected to a first word line for a row. Each bit cell can also include a second transistor, which is connected between the first end node and the second end node. A second gate of the second transistor can be connected to a second word line for the row. The bit cells in the columns can be connected in series, thereby forming bit cell stacks and the method can further include performing a read operation to concurrently compute majority functions directed to stored bit values in selected rows of the bit cell stacks.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1 is a schematic diagram illustrating disclosed embodiments of a bit cell;
FIGs. 2A-2C are cross-section diagrams illustrating an example resistive random access memory-type variable resistor in different resistance states, respectively;
FIGs. 3A and 3B are cross-section diagrams illustrating an example magnetic tunnel junction-type variable resistor in different resistance states, respectively;
FIGs. 4A and 4B are cross-section diagrams illustrating an example phase change memory-type variable resistor in different resistance states, respectively;
FIG. 5 is a schematic diagram illustrating, generally, disclosed embodiments of an in-memory computing circuit;
FIGs. 6-8 are schematic diagram illustrating various configurations, respectively, for some of the components of the circuit of FIG. 5;
FIG. 9 is a schematic diagram illustrating an alternative example of a reference signal generator that could be incorporated into the circuit of FIG. 5; and
FIG. 10 is a flow diagram illustrating disclosed embodiments of an in-memory computing method.

### DETAILED DESCRIPTION

As mentioned above, recently, specialized analog in-memory computing (AiMC) circuits have been developed for some of these complex functions (e.g., multiply-accumulate (MAC) functions). It could, however, be advantageous to have such specialized AiMC circuits for other complex functions, such as majority functions.

In view of the foregoing disclosed herein are embodiments of a uniquely configured bit cell. The bit cell can include: a variable resistor (which can be programmed or erased to have a low resistance state (LRS) or a high resistance state (HRS), respectively) and a first transistor (also referred to herein as a read-write access transistor), which are connected in series between two end nodes. The bit cells can also include a second transistor (also referred to herein as a read bypass transistor), which is also connected between the two end nodes. Within the bit cell, a first gate of the first transistor can be connected to a first word line for a row and a second gate of the second transistor can be connected to a second word line for the same row. As discussed in greater detail below, the bit cell can further include additional transistors connected to additional word lines, respectively, to enable write operations to be directed to the variable resistor therein (e.g., to switch the variable resistor between a low resistance state (LRS) (e.g., to store a "1" bit value) and a high resistance state (HRS) (e.g., to store a "0" bit value).

Also disclosed herein are embodiments of an in-memory computing circuit suitable, for example, for computing majority functions, and of an associated in-memory computing method. The in-memory computing circuit can include an array of such bit cells arranged in columns and rows. **In** each column, the bit cells can be series-connected end node-to-end node (forming a bit cell stack) between a sense amplifier and a footer device for the column. In the in-memory computing circuit, a read operation can be performed to concurrently compute multiple majority functions. The majority functions are associated with corresponding columns and are based on the stored bit values in bit cells located in the same selected rows of the bit cell stacks in those columns. To accomplish the read operation, the footer devices can all be switched on to concurrently connect the bit cell stacks to ground and initiate current flow through the bit cell stacks. First and second word line voltages applied to the first and second word lines of the selected rows cause the first transistors of the bit cells in the selected rows to turn on and the second transistors to turn off. Opposite first and second word line voltages applied to the first and second word lines of any unselected rows cause the first transistors of the bit cells in the unselected rows to turn off and the second transistors turn on (in order to bypass the variable resistors in those bit cells). Resistances of each bit cell stack are sensed by sense amplifiers connected thereto. The sensed resistance of each bit cell stack will depend on the different resistance states (LRS or HRS) of variable resistors in bit cells of the selected rows, but not on the resistance states of the variable resistors in the bit cells of the unselected rows. Each sense amplifier will compare the sensed resistance (e.g., as indicated by a sensing current (Isen)) to a reference resistance (e.g., as indicated by a reference current (Iref)), which is equal to the expected sensed resistance when half of the variable resistors of the bit cells in the selected rows are in the LRS and half are in the HRS. Thus, the data output signal (Dout) from each sense amplifier will indicate whether or not a majority of the variable resistors in the bit cells of the selected rows in the bit cell stack store a"1" bit value or a "0" bit value.

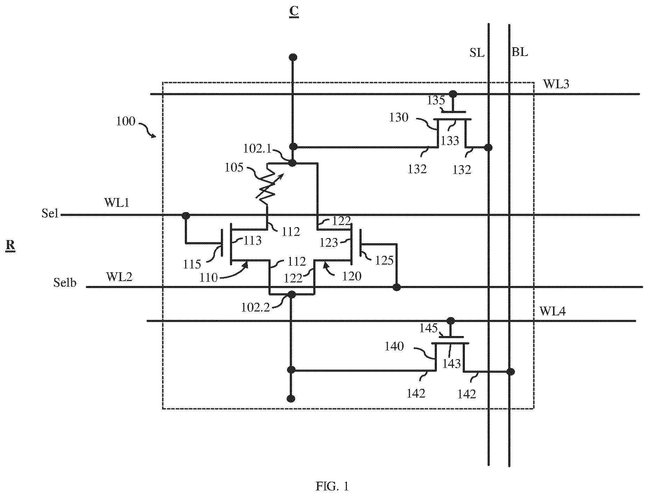

More particularly, FIG. 1 is a schematic diagram illustrating disclosed embodiments of a bit cell (herein after referred to as bit cell 100). As discussed in greater detail below, bit cell 100 can be included in an array of bit cells in an in-memory computing circuit.

Bit cell 100 can include a variable resistor 105. Variable resistor 105 can be any currently known or later developed type of resistor having a selectively variable resistance and, particularly, that can be switched between at least two different resistance state including a high resistance state (HRS) and a low resistance state (LRS). The HRS can indicate a stored bit with a first bit value (e.g., a bit value of "0") and the LRS can indicate a stored bit with a second bit value (e.g., a bit value of "1"). Such variable resistors include, but are not limited to, resistive random access memory (RRAM)-type variable resistors (e.g., also referred to as memristors), magnetic tunnel junction (MTJ)-type variable resistors, and phase change memory (PCM)-type variable resistor.

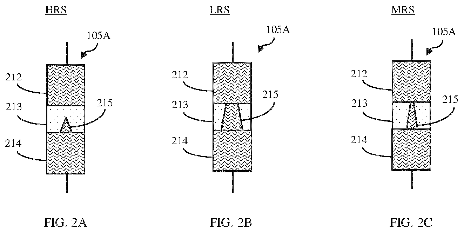

FIGs. 2A-2C are cross-section diagrams illustrating an example RRAM-type variable resistor 105A in different resistance states, respectively. Such an RRAM-type variable resistor 105A is also typically a back end of the line (BEOL) multi-layer structure, which includes two metal layers 212 and 214 separated by a dielectric layer 213 (e.g., hafnium oxide (HfOₓ) or some other suitable oxide layer, also referred to as a switching layer). Depending upon the biasing conditions on metal layers 212 and 214 during a write operation, ions in dielectric layer 213 may migrate to: (a) break-up a conductive filament 215 extending between metal layers 212 and 214 so that RRAM-type variable resistor 105A is in the HRS, thereby storing one bit value (e.g., a logic value of "0") (e.g., see FIG. 2A) or (b) grow conductive filament(s) 215 in dielectric layer 213 extending between metal layers 212 and 214 so that RRAM-type variable resistor 105A is the LRS, thereby storing a different bit value (e.g., a logic value of "1") (e.g., see FIG. 2B). Optionally, different biasing conditions could be employed to achieve one or more different resistance states between the HRS and the LRS. For example, as illustrated in FIG. 2C, optionally specific biasing conditions on metal layers 212 and 214 could be employed to achieve a middle level resistance state (MRS) that is half-way between LRS and HRS.

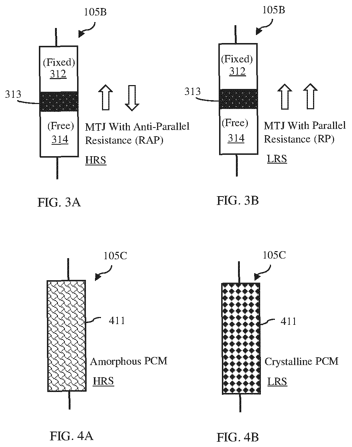

FIGs. 3A and 3B are cross-section diagrams illustrating an example MTJ-type variable resistor 105B in different resistance states, respectively. Such a MTJ-type variable resistor 105B is typically a BEOL multi-layer structure, which includes a free ferromagnetic layer 314 (also referred to as a switchable layer) and a fixed ferromagnetic layer 312 (also referred to as a pinned layer) separated by a thin dielectric layer 313 (e.g., a thin oxide layer or some other suitable type of dielectric layer). Depending upon the biasing conditions on ferromagnetic layers 312 and 314 during a write operation, MTJ-type variable resistor 105B may switch between an anti-parallel resistance (RAP) state (i.e., a HRS, as shown in FIG. 3A) and a parallel resistance (RP) state (i.e., a LRS, as shown in FIG. 3B).

FIGs. 4A and 4B are cross-section diagrams illustrating an example PCM-type variable resistor 105C in different resistance states, respectively. Such a PCM-type variable resistor employs a phase change material 411 (e.g., a chalcogenide compound) with programmable structural phases that exhibit different resistances. Depending upon the biasing conditions on opposite terminals of resistor and, thus, the local temperature, the PCM may switch between an amorphous phase (i.e., a HRS, as shown in FIG. 4A) and a crystalline phase (i.e., a LRS, as shown in FIG. 4B).

Such variable resistors and the biasing conditions necessary to switch resistance states thereof during write operations are known in the art. Thus, more specific details have been omitted from this specification in order to allow the reader to focus on the salient aspects of the disclosed embodiments related, for example, to the structure of bit cell 100 itself and to its incorporation into an in-memory computing circuit.

Referring again to FIG. 1, bit cell 100 can also include a first transistor 110 (also referred to herein as a read-write access transistor). Variable resistor 105 and first transistor 110 can be electrically connected in series between a pair of end nodes (i.e., a first end node 102.1 and a second end node 102.2). Bit cell 100 can further include a second transistor 120 (also referred to herein as a bypass transistor), which is electrically connected in parallel with variable resistor 105 and first transistor 110 between end nodes 102.1-102.2. First transistor 110 and second transistor 120 can be field effect transistors (FETs). First transistor 110 can include at least a first channel region 113 positioned laterally between first source/drain regions 112 and a first gate 115 adjacent to first channel region 113. First gate 115 can be electrically connected to a first word line (WL1) such that the on/off state of first transistor 110 depends on a first word line voltage (VWL1) on WL1. Similarly, second transistor 120 can include at least a second channel region 123 positioned laterally between second source/drain regions 122 and a second gate 125 adjacent to second channel region 123. Second gate 125 can be electrically connected to a second word line (WL2) such that the on/off state of second transistor 120 depends on a second word line voltage (VWL2) on WL2.

Bit cell 100 can further include a third transistor 130 and a fourth transistor 140 (also referred to as additional access transistors), which can be employed to facilitate write operations directed to variable resistor 105 (e.g., to switch the resistance state of variable resistor 105). Third transistor 130 and fourth transistor 140 can also be FETs. Third transistor 130 can include at least a third channel region 133 positioned laterally between third source/drain regions 132 (which are connected to a source line (SL) and first end node 102.1) and a third gate 135 adjacent to third channel region 133. Third gate 135 can be electrically connected to a third word line (WL3) such that the on/off state of third transistor 130 depends on a third word line voltage (VWL3) on WL3. Fourth transistor 140 can include at least a fourth channel region 143 positioned laterally between fourth source/drain regions 142 (which are connected to a bit line (BL) and second end node 102.2) and a fourth gate 145 adjacent to third channel region 133. Fourth gate 145 can be electrically connected to a fourth word line (WL4) such that the on/off state of fourth transistor 140 depends on a fourth word line voltage (VWL4) on WL4.

In some embodiments, as illustrated, these four transistors 110, 120, 130, and 140 can all be N-type field effect transistors (NFETs) (as shown). That is, in each of the four transistors 110, 120, 130, and 140, the source/drain regions can have N-type conductivity at a relatively high conductivity level and the channel region can have either P-type conductivity at a relatively low conductivity level (or alternatively can be an intrinsic channel region). In such embodiments, WL1 and WL2 can be connected to receive a read-write select signal (Sel) to set VWL1 and an inverted read-write select signal (Selb) to set VWL2, respectively. WL3 and WL4 can each receive the same write select signal (WSel). Thus, in memory operations, if first transistor 110 is in an on-state, second transistor 120 will be in an off-state or vice versa and third and fourth transistors 130 and 140 will either both be in an on-state or both be in an off-state.

For example, end nodes 102.1 and 102.2 can be connectable to a positive supply voltage rail and a ground rail, respectively, during a read operation. If bit cell 100 is in a selected row during this read operation, then Sel can be high, Selb can be low, and WSel can be low. Thus, first transistor 110 turns on and second transistor 120, third transistor 130 and fourth transistor 140 are off. As a result, current is flowable through variable resistor 105 and first transistor 110 between end nodes 102.1 and 102.2. If bit cell 100 is in an unselected row during the read operation, then Sel can be low, Selb can be high, and WSel can be low. Thus, second transistor 120 turns on and first transistor 110, third transistor 130 and fourth transistor 140 are off. As a result, current is flowable through second transistor 120 between end nodes 102.1 and 102.2 bypassing variable resistor 105.

If bit cell 100 is in a selected row and column for a write operation (e.g., to write either a LRS or a HRS into variable resistor 105 therein), SL and BL can be biased (as necessary depending upon the desired resistance state being written into the programmable resistor). Sel and WSel can be high and Selb can be low. Thus, a first transistor 110, third transistor 130 and fourth transistor 140 turn on and second transistor 120 is off. As a result, a source line voltage (VSL) on SL will be applied through third transistor 130 and first end node 102.1 to one terminal of variable resistor 105 and a bit line voltage (VBL) on BL will be applied through fourth transistor 140, second end node 102.2, and first transistor 110 to the opposite terminal of variable resistor 105 to achieve the desired resistance state.

In other embodiments (not shown), the conductivity type of one or more of the transistors 110, 120, 130 and 140 could vary. For example, in an alternative embodiment, first and second transistors 110 and 120 could be PFETs. In another alternative embodiment, first transistor 110 could be an NFET and second transistor 120 could be a PFET (or vice versa). It should be understood that in any of these alternative embodiments the voltage levels of VWL1 and VWL2 would be different that the voltage levels for VWL1 and VWL2 as discussed above with respect to embodiments where all of the transistors are NFETs. For example, in an embodiment where first transistor 110 and second transistor 120 are both PFETs, a low Sel and high Selb will be required to concurrently turn on first transistor 110 and turn off second transistor 120 (and vice versa). In an embodiment where first transistor 110 is an NFET and second transistor 120 is a PFET (or vice versa), the same Sel can be employed to control the on/off states of both transistors and, in this case, first gate 115 of first transistor 110 and second gate 125 of second transistor 120 could be electrically connected to the same word line.

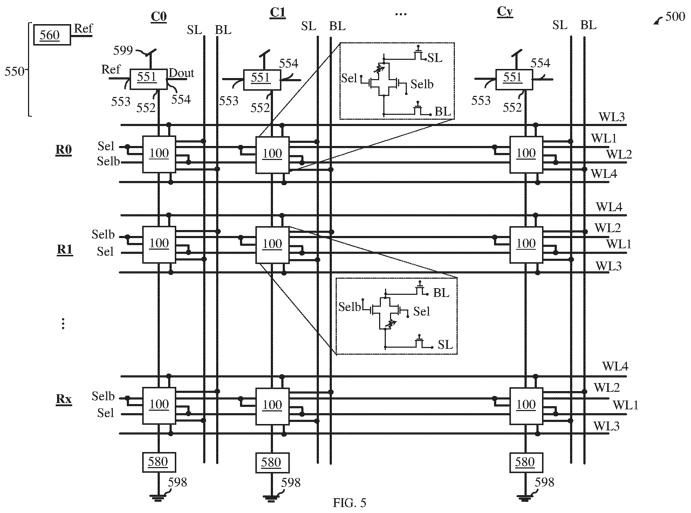

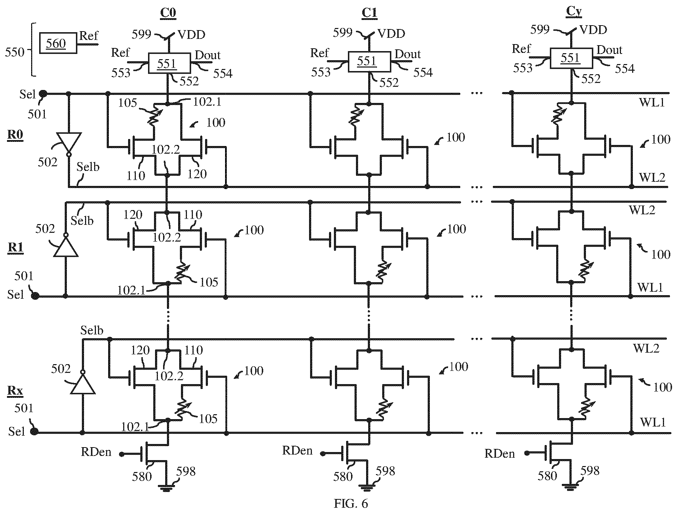

FIG. 5 is a schematic diagram illustrating, generally, disclosed embodiments of an in-memory computing circuit (hereinafter referred to as structure 500). Structure 500 can include an array of bit cells 100 (e.g., as described in detail above and illustrated in FIG. 1). The bit cells 101 can be arranged in columns (e.g., see columns C0-Cy) and rows (e.g., see rows R0-Rx). FIGs. 6-8 are schematic diagrams illustrating, in more specific detail, various configurations, respectively, for some of the components of structure 500 of FIG. 5. As illustrated in FIGs. 5-8, within each column, all bit cells 100 can be electrically connected (e.g., end node-to-end node) in series. Such that each column includes a bit cell stack (i.e., a stack of bit cells connected in series).

Structure 500 can further be configured, as described in greater detail below, to facilitate the performance of majority functions associated with data stored in the bit cells of the bit cells stacks, respectively, and, more particularly, stored in the same selected rows therein.

For example, structure 500 can include multiple word lines for the rows, respectively. These word lines can include a first word line (WL1), a second word line (WL2), a third word line (WL3), and a fourth word line (WL4). In the same manner as discussed above with regard to each individual bit cell 100 (as shown in FIG. 1) and also illustrated in the more detailed schematic diagrams of FIGs. 6-8, in a given row: WL1 for the row can be electrically connected to the first gates 115 of all first transistors 110 in all bit cells 100 in the row; WL2 for the row can be electrically connected to the second gates 125 of all second transistors 120 in all bit cells 100 in the row; WL3 for the row can be electrically connected to the third gates 135 of all third transistors 130 in all bit cells 100 in the row; and WL4 for the row can be electrically connected to the fourth gates 145 of all fourth transistors 140 in all bit cells 100 in the row.

WL1 for each row can be connected to receive row-specific first word line voltage (VWL1) and, particularly, a row-specific read-write select signal (Sel)) and WL2 for each row can be connected to receive a row-specific second word line voltage (VWL2) and, particularly, a row-specific inverted read-write select signal (Selb). In some embodiments (e.g., see FIGs. 6-8), structure 500 can include: select signal input nodes 501 on each WL1 for each row to receive the row-specific Sel; and inverters 502 for the rows, respectively. Each inverter 502 for a row can be electrically connected between select signal input node 501 on WL1 for the and WL2 for the same row (i.e., to output and apply Selb to WL2).

Structure 500 can also include a source line (SL) and a bit line (BL) for each column. In the same manner as discussed above with regard to each individual bit cell 100 (as shown in FIG. 1), the third transistors 130 of all bit cells 100 in the same column can be electrically connected to the SL for that column and the fourth transistors 140 of all bit cells 100 in the same column can be electrically connected to the BL for that column. To avoid clutter in the figures and allow the reader to focus on the salient aspects of the disclosed embodiments (e.g., related to in-memory computing and, particularly, performance of a read operation to concurrently solve majority functions), the SLs and BLs for the columns as well as the third and fourth transistors 130-140 of the bit cells 101 connected thereto have been omitted from FIGs. 6-8.

Structure 500 can also include additional components (e.g., a controller and peripheral circuitry) connected to the array to facilitate performance of memory operations therein (e.g., by establishing specific read-dependent or write-dependent biasing conditions on WLs, SLs, and BLs connected to the bit cells in the array). Controllers and peripheral circuity configured to facilitate performance of memory operations are known in the art. Thus, the details thereof have been omitted from the specification and figures in order to allow the reader to focus on the salient aspect of the disclosed embodiments (e.g., related to in-memory computing and, particularly, performance of a read operation to concurrently solve majority functions).

Structure 500 can include a sense circuit 550. Sense circuit 550 can include a reference signal generator 560, which is configured (as discussed in greater detail below) to generate and output a reference signal (Ref). Ref can, for example, include a reference voltage (Vref) and a reference current (Iref) generated from Vref. Sense circuit 550 can further include multiple sense amplifiers 551, which are electrically connected to one end of each of the bit cell stacks of the columns, respectively, and to reference signal generator 560 for receiving Ref.

Specifically, each sense amplifier 551 can be connected between a bit cell stack and a positive supply voltage rail (e.g., at a positive supply voltage level (VDD)) and can further be connected to reference signal generator 560 for receiving Ref. For example, each sense amplifier 551 can include: a first terminal 552 (also referred to herein as a sense signal node), which is connected to apply a sense voltage (Vsen) to one end of the bit cell stack (e.g., from end node 102.1 of first bit cell 101 in R0) to generate a sense current (Isen); a second terminal 553 (also referred to herein as a reference signal node), which is electrically connected to receive Ref (and thereby Vref and Iref generated by Vref); and a data output signal node 554, which outputs a data output signal (Dout) based on results of a comparison between Iref and Isen .

In some embodiments, each sense amplifier 551 for each column can include: a P-type field effect transistor (PFET) 572 and an N-type field effect transistor (NFET) 571, which are connected in series between a positive supply voltage rail 599 at a positive supply voltage level (i.e., at VDD) and a first terminal 552, which, as mentioned above, is connected to a bit cell stack for the column (e.g., at end node 102.1 of the bit cell 101 in row R0 of the bit cell stack for the column). Each sense amplifier 551 can also include a comparator 576 (e.g., an operational amplifier). The comparator 576 can have a non-inverting input (+) connected to a second terminal 553 to receive Ref (and thereby Vref and Iref) and an inverting input (-) connected to an intermediate node 575 at a junction between PFET 572 and NFET 571. Gates of PFET 572 and NFET 571 can be connected to receive Ref (and thereby Vref and Iref) and a bias voltage (Vbias) (e.g., from a bias voltage generator 569), respectively, so that Isen is generated and a sense voltage (Vsen) is on intermediate node 575.

It should be noted that to perform majority functions, as discussed in greater detail below, the voltage level of Vref can be a mid-level voltage. This mid-level voltage can be determined so that Iref (which is generated as a function of Vref) corresponds to an expected reference current from a single bit cell stack if one half of the programmable resistors of the bit cells located in some number of selected rows in that bit cell stack are in the LRS and if the other half are in the HRS. Thus, when Iref and Isen are compared by a sense amplifier 551, Dout can be low, if Isen is less than the Iref, thereby indicating that the majority of the variable resistors of the bit cells in the selected rows of the bit cell stack have the HRS. Furthermore, Dout can be high, if Isen is greater than Iref, thereby indicating that the majority of the variable resistors of the bit cells in the selected rows of the bit cell stack have the LRS. Various different techniques could be employed to generate a Ref with such a Vref (and thereby such a Iref).

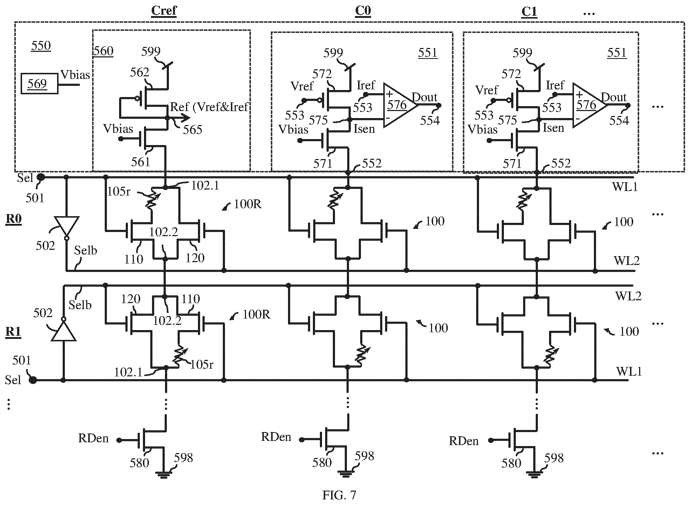

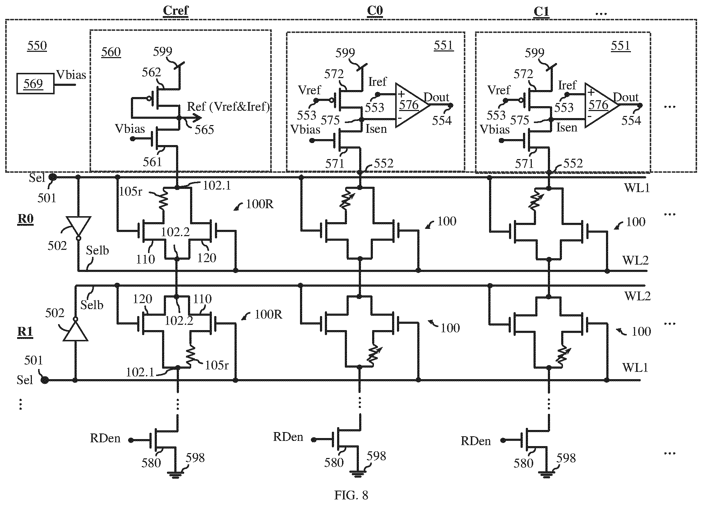

For example, in some embodiments, as illustrated in FIGs. 6 and 7, the array of bit cells can also include a reference column (Cref) of reference bit cells 100R. Each reference bit cell 100R can include a reference resistor 105r, which has a mid-level resistance state (MRS). That is, the resistance of reference resistor 105r can be half-way between the resistance of a variable resistor 105 in the HRS and the resistance of a variable resistor 105 in the LRS. In some embodiments (as illustrated in FIG. 7), this reference resistor 105r can be yet another variable resistor that is programmable to this MRS. In other embodiments (as illustrated in FIG. 8), the reference resistor 105r can be a fixed resistor that has this MRS. In any case, reference bit cells 100R can be configured essentially the same as bit cells 100 (e.g., reference resistor 105r and a first transistor 110 can be connected in series between end nodes and a second transistor 120 can be connected in parallel with the reference resistor 105r and first transistor 110 also between the end nodes). However, it should be noted that, in embodiments where reference resistor 105r is a fixed resistor, no write operations are required. Thus, the reference column does not require a SL or BL and reference bit cells 100R therein would be devoid of the third and fourth transistors. In any case, reference bit cells 100R can be electrically connected in series to form a reference bit cell stack. The reference bit cell stack can be connected between reference signal generator 560 (as opposed to a sense amplifier) and an additional footer device 580. In embodiments having such a reference column, reference signal generator 560 can include: an additional PFET 562 and an additional NFET 561, which are connected in series between the positive supply voltage rail 599 and the reference bit cell stack (e.g., at an end node of the reference bit cell 100R in row R0). The gate of additional PFET 562 can be connected to a reference signal output node 565 at a junction between the additional PFET 562 and additional NFET 561. The gate of additional NFET 561 can be connected to receive Vbias (e.g., from bias voltage generator 569), respectively. As a result, Ref (including a Vref and Iref generated as a function of Vref) can be generated at reference signal output node 565 and output the second terminal 553 of each sense amplifier 551.

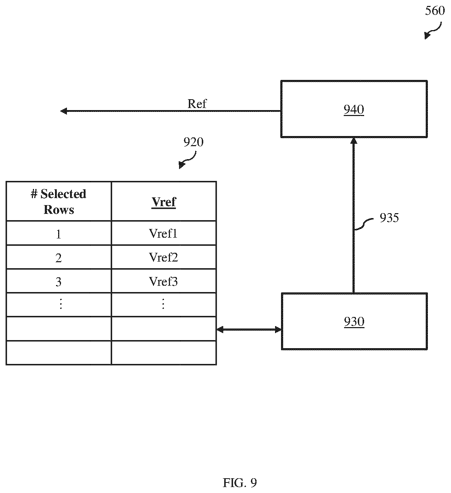

Alternatively, any other suitable technique could be employed to generate a Ref (including Vref and Iref, as described in detail above). For example, in other embodiments, Ref generation including Vref generation could be look-up table based. FIG. 9 is a schematic diagram illustrating another example of a reference signal generator 560 that could be incorporated into structure 500. Reference signal generator 560 can include a look-up table (LUT) 920. LUT 920 can be populated with a data indicating different numbers of selected rows and a data indicating different Vref levels that should be employed depending upon the number of selected rows. Reference signal generator 560 can further include a variable voltage source 940, and control logic 930 in communication with LUT 920, a controller, and variable voltage source 940. Control logic 930 could receive an input signal indicating the total number of selected rows to be used during a read operation, can identify the particular Vref level associated with that number of selected rows in LUT 920, and can output a control signal 935 to variable voltage source 940 indicative of that particular Vref level such that variable voltage source 940 outputs a Ref with correct Vref. Generally, circuit structures that include an LUT, a variable voltage source, and control logic, which controls the voltage output from the variable voltage source based on LUT acquired information, are known in the art. Thus, the details thereof have been omitted from this specification in order to allow the reader to focus on the salient aspects of the disclosed embodiments.

In any case, structure 500 can further include footer devices 580 for the columns, respectively. As illustrated in FIGs. 5-8, each bit cell stack for each column can be electrically connected between a sense amplifier 551 for the column and a footer device 580 for the column. Thus, each column includes the bit cell stack (i.e., a stack of series-connected bit cells 101), which is connected to a sense amplifier 551 at one end and to a footer device 580 at the opposite end. Specifically, within each column, the first bit cell in the bit cell stack at R0 can be electrically connected the sense amplifier 551 for the column and the last bit cell in the bit cell stack at Rx can be electrically connected to the footer device 580 for the column.

Each footer device 580 for each column can be controllable to connect the bit cell stack to ground 598 or disconnect the bit cell stack from ground 598, as discussed below. For example, each footer device 580 can include an NFET. This NFET can include: source/drain regions, which are connected to the last bit cell in the column at issue at Rx and to ground 598, respectively; and a gate, which is connected to receive a read enable signal (RDen). Optionally, all footer devices 580 can be connected to receive the same RDen so that they concurrently connect the bit cell stacks to ground or disconnect them from ground. Alternatively, footer devices 580 could have any other suitable footer device configuration. For example, each footer device 580 could include multiple stacked NFETs between a bit cell stack and ground and controlled by the same RDen. Alternatively, each footer device could include a transmission gate including an NFET and a PFET connected in parallel between the bit cell stack and ground 598 and controlled by RDen and RDenb, respectively.

As mentioned above, structure 500 is configured so that a read operation can be employed to concurrently solve multiple majority functions. The majority functions can be associated with corresponding columns and can be based on the stored bit values in bit cells located in the same selected rows of the bit cell stacks in those columns. During such a read operation, WL1s for all selected rows receive row-specific Sels that cause all first transistors of all bit cells in the selected rows to turn on and WL2s for those same selected rows receive row-specific Selbs that turn off all second transistors 120 of the bit cells 101 in the selected rows. Meanwhile, WL1s for all unselected rows receive row-specific Sels that cause all first transistors of all bit cells in the unselected rows to turn off and WL2s for those same unselected rows receive row-specific Selbs that turn on all second transistors 120 of the bit cells 101 in the unselected rows. For example, if first transistor 110 and second transistor 120 in each bit cell 101 are NFETs, WL1 and WL2 for each selected row can receive a high Sel and a low Selb, respectively, whereas WL1 and WL2 for each unselected row can receive a low Sel and a high Selb. Additionally, RDen can switch states (e.g., can go high in the case of NFET footer devices) to electrically connect the bit cell stacks of all of the columns to ground. As a result, current begins to flow from the positive supply voltage rail 599 to ground 598 through the bit cells 101 in each bit cell stack. The current flow within each bit cell stack passes through the variable resistors 105 in the bit cells 101 in the selected rows (in which first transistors 110 are on and second transistors are off) but bypasses the variable resistors 105 in the bit cells 101 in any unselected rows (in which first transistors 110 are off and second transistors 120). Depending upon the resistance states of the variable resistors 105 in the bit cells in the selected rows in each bit cell stack for each column, the sensing current (Isen) will vary (e.g., will be lower if more of the variable resistors 105 are in the HRS and higher if more of the variable resistors 105 are in the LRS).

During the read operation, each sense amplifier 551 for each column can receive Ref (e.g., from reference signal generator 560, as discussed in greater detail above), can apply Vsen to the bit cell stack of the column (e.g., from end node 102.1 of first bit cell 101 in R0), can compare Iref generated from Vref to the Isen generated from Vsen, and can output a Dout based on results of the comparison, as discussed above. Thus, Dout from each sense amplifier 551 for each column is the solution to a majority function directed to the stored bit values of bit cells in only selected rows in the bit cell stack of that column.

It should be noted that, during the above-described read operation, Vbias of sense amplifier 551 (e.g., as shown in FIGs. 7 and 8) can be set to approximately a Vtn above the target voltage Vsen to be applied at the top of each bit cell stack when sensing. When first transistor 110 and second transistor 120 in each bit cell 101 are NFETs, this target voltage should not be too high or Vgs of the stacked NFETs closest to the sense amplifier 551 will have a low Vgs and higher resistance. Optimally, the target voltage at the top of the bit cell stack should be <1/2 VDD. Furthermore, it should be noted that NFET 571 acts as a source voltage follower within sense amplifier 551 to regulate the voltage at the top of the bit cell stack and PFET 572 acts as a current mirror within sense amplifier 551 to pull up with the reference current. The intermediate node 575, which is between the PFET 572 and NFET 571 and which is also connected to inverting input of comparator 576, responds to differences between currents flowing through PFET 572 and NFET 571. Additionally, it should be noted that, during the above-described read operation, additional PFET 562 of reference signal generator 560 (which is connected to the reference bit cell stack in the reference column, as illustrated in FIGs. 7-8) functions as a diode connected to act as the reference side of the current mirror. The Vgs of PFET 562 in reference signal generator 560 and PFETs 572 in the sense amplifiers 551 should settle to where each PFET is biased to drive the reference current.

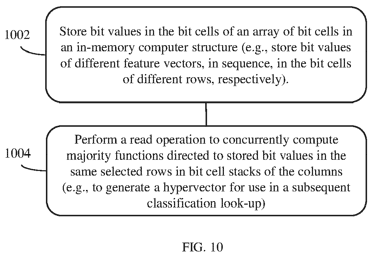

FIG. 10 is a flow diagram illustrating disclosed embodiments of an in-memory computing method performed using any of the different embodiments of structure 500, as described in detail above and illustrated through FIGs. 1-9. Specifically, the method can include storing bit values in bit cells 100 within the array of bit cells in structure 500 (see process 1002). The method can further include performing a read operation, as discussed above, to concurrently compute majority functions directed to stored bit values in the same selected rows of bit cell stacks of the columns in the array (see process 1004). Optionally, this in-memory computing method can be employed for hyperdimensional computing (HDC) in AI applications. In this case, at process 1002, the bit values of feature vectors (e.g., binded feature vectors) can be stored, in sequence, within the bit cells of the row, respectively, in the array. Thus, the bit cells in each row store a different feature vector. Then, at process 1004, the read operation is performed to concurrently compute majority functions directed to stored bit values in the same selected rows of bit cell stacks of the columns in the array. Thus, each majority function is directed to stored bit values at the same bit location within different feature vectors stored in different selected rows. For example, the majority function associated with C0 is directed to bit values stored at the first bit location within the different feature vectors stored in the different selected rows; the majority function associated with C1 is directed to bit values stored at the second bit location within the different feature vectors stored in the different selected rows; and so on. Thus, outputs of these majority functions can be compiled, in sequence (e.g., Dout from C0, Dout from C1, etc.) to form a hypervector for use in a subsequent classification look-up.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. **In** the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

The following embodiments are explicitly disclosed.

### Embodiment 1:

A bit cell comprising:
a variable resistor and a first transistor connected in series between a first end node and a second end node, wherein a first gate of the first transistor is connected to a first word line; and
a second transistor connected between the first end node and the second end node, wherein a second gate of the second transistor is connected to a second word line.

### Embodiment 2:

The bit cell of claim 1, wherein the variable resistor is any of a resistive random access memory-type variable resistor, a magnetic tunnel junction-type variable resistor, and a phase change memory-type variable resistor.

### Embodiment 3:

The bit cell of claim 1 or 2, further including:
a third transistor connected between the first end node and a source line, wherein a third gate of the third transistor is connected to a third word line; and
a fourth transistor connected between the second end node and a bit line, wherein a fourth gate of the fourth transistor is connected to a fourth word line.

### Embodiment 4:

The bit cell of one of claims 1 to 3, wherein the first transistor, the second transistor, the third transistor and the fourth transistor are N-type field effect transistors.

In special illustrative examples herein, embodiment 4 may refer back to embodiment 3.

### Embodiment 5:

The bit cell of claim 1,
wherein a resistance state of the variable resistor is switchable between at least a high resistance state and a low resistance state that is lower than the high resistance state depending on word line voltage levels on the first word line, the second word line, the third word line, the fourth word line, the source line, and the bit line, and
wherein the high resistance state is indicative of a first bit value stored in the variable resistor and the second resistance state is indicative of a second bit value stored in the variable resistor.

### Embodiment 6:

The bit cell of claim 5, wherein, during a memory operation, the first word line is connected to receive a first word line voltage and the second word line is connected to receive a second word line voltage that is inverted relative to the first word line voltage causing one of the first transistor and the second transistor is conductive.

### Embodiment 7:

The bit cell of claim 5 or 6, wherein the low resistance state is indicative of a "1" bit value stored in the variable resistor and the high resistance state is indicative of a "0" bit value stored in the variable resistor.

### Embodiment 8:

The bit cell of one of claims 5 to 7,
wherein the resistance state of the variable resistor is switchable between the high resistance state, the low resistance state, and a mid-level resistance state between the high resistance state and the low resistance state, and
wherein the bit cell is employable as a reference bit cell when the variable resistor has the mid-level resistance state.

### Embodiment 9:

An in-memory computing circuit comprising:
an array of bit cells in columns and rows;
first word lines for the rows, respectively; and
second word lines for the rows, respectively, wherein each bit cell includes:
   a variable resistor and a first transistor connected in series between a first end node and a second end node, wherein a first gate of the first transistor is connected to a first word line for a row; and a second transistor connected between the first end node and the second end node, wherein a second gate of the second transistor is connected to a second word line for the row.

In some illustrative examples of embodiment 9, the each bit cell may be formed in accordance with one of embodiments 1 to 8.

Accordingly, some illustrative examples of embodiment 9 may provide for an in-memory computing circuit, comprising:
an array of bit cells in columns and rows;
first word lines for the rows, respectively; and
second word lines for the rows, respectively, wherein each bit cell is formed in accordance with the bit cell of each of claims 1 to 7 and, wherein, for each bit cell:
   the first gate of the first transistor is connected to a first word line for a row; and
   the second gate of the second transistor is connected to a second word line for the row.

### Embodiment 10:

The in-memory computing circuit of claim 9, wherein the variable resistor is any of a resistive random access memory-type variable resistor, a magnetic tunnel junction-type variable resistor, and a phase change memory-type variable resistor.

In some illustrative examples herein, the first transistor, the second transistor, the third transistor, and the fourth transistor may be N-type field effect transistors.

### Embodiment 11:

The in-memory computing circuit of claim 9 or 10,
wherein each bit cell further includes:
a third transistor connected between the first end node and a source line for the column, wherein
a third gate of the third transistor is connected to a third word line for the row; and
a fourth transistor connected between the second end node and a bit line for the column, wherein
a fourth gate of the fourth transistor is connected to a fourth word line for the row, and
wherein the in-memory computing circuit further includes:
   sense amplifiers for the columns, respectively; and
   footer devices for the columns, respectively, wherein the bit cells in each column are electrically connected in series between a sense amplifier and a footer device for the column.

### Embodiment 12:

The bit cell of one of claims 9 to 11, wherein the first transistor, the second transistor, the third transistor, and the fourth transistor are N-type field effect transistors.

### Embodiment 13:

The in-memory computing circuit of one of claims 9 to 12,
wherein a resistance state of the variable resistor is switchable between at least a high resistance state and a low resistance state that is lower than the high resistance state, and
wherein the high resistance state is indicative of a first bit value stored in the variable resistor and the second resistance state is indicative of a second bit value stored in the variable resistor.

### Embodiment 14:

The in-memory computing circuit of claim 13, wherein the low resistance state is indicative of a "1" bit value stored in the variable resistor and the high resistance state is indicative of a "0" bit value stored in the variable resistor.

### Embodiment 15:

The in-memory computing circuit of one of claims 9 to 14,
wherein, during a read operation to concurrently compute majority functions directed to stored bit values in selected rows of bit cell stacks of the columns:
first and second word lines for the selected rows receive first and second word line voltages to turn on all first transistors of all bit cells in the selected rows and turn off all second transistors of the bit cells in the selected rows,
first and second word lines for any unselected rows receive opposite first and second word line voltages to turn off all first transistors in all bit cells in the unselected rows and to turn on all second transistors of the bit cells in the unselected rows,
the footer devices receive a read enable signal to electrically connect the bit cell stacks of the columns to ground, and
each sense amplifier for each column compares a sense current from a bit cell stack of the column to a reference current and outputs a corresponding data output signal,
wherein the reference current is equal to an expected sense current level when one-half of the bit cells in the selected rows in the bit cell stack store the "1" bit value, and
wherein the corresponding data output signal indicates whether a majority of the bit cells in the bit cell stack store the "1" bit value.

### Embodiment 16:

The in-memory computing circuit of claim 15, wherein each sense amplifier for each column includes a first input terminal connected to one end of the bit cell stack, a second input terminal connected to receive the reference voltage node, and a data output signal node.

### Embodiment 17:

The in-memory computing circuit of claim 15 or 16,
wherein the array further includes a reference column of reference bit cells, each reference bit cell including a reference resistor having a mid-level resistance state between a high resistance state and a low resistance state, and
wherein the reference bit cells in the reference column are electrically connected in series to form a reference bit cell stack between a reference signal generator and an additional footer device for the reference column.

### Embodiment 18:

The in-memory computing circuit of claim 17, wherein the reference resistor has any one of a fixed resistance and a variable resistance.

### Embodiment 19:

The in-memory computing circuit of claim 17 or 18,
wherein each sense amplifier for each column includes:
a P-type field effect transistor and an N-type field effect transistor connected in series between a positive supply voltage rail and the bit cell stack for the column; and
a comparator having a non-inverting input connected to receive the reference voltage and an inverting input connected to an intermediate node at a junction between the P-type field effect transistor and the N-type field effect transistor,
wherein gates of the P-type field effect transistor and the N-type field effect transistor are connected to a reference signal output node of the reference signal generator and a bias voltage generator, respectively,
wherein the reference signal generator includes an additional P-type field effect transistor and an additional N-type field effect transistor connected in series between the positive supply voltage rail and the reference bit cell stack and further includes the reference signal output node at a junction between the additional P-type field effect transistor and the additional N-type field effect transistor, and
wherein gates of the additional P-type field effect transistor and the additional N-type field effect transistor are connected to the reference signal output node and the bias voltage generator, respectively.

### Embodiment 20:

An in-memory computing method comprising:
storing bit values in bit cells of an array of the bit cells arranged in columns and rows,
wherein each bit cell includes:
   a variable resistor and a first transistor connected in series between a first end node and a second end node, wherein a first gate of the first transistor is connected to a first word line for a row; and
   a second transistor connected between the first end node and the second end node, wherein a second gate of the second transistor is connected to a second word line for the row, and
   wherein the bit cells in the columns are connected in series forming bit cell stacks; and
   performing a read operation to concurrently compute majority functions directed to stored bit values in selected rows of the bit cell stacks.

**In** some illustrative embodiments of embodiment 20, each bit cell of the bit cells may be formed in accordance with one of embodiments 1 to 8 and/or the in-memory computing method of embodiment 20 may be applied to the in-memory computing circuit of one of embodiments 9 to 19.

**In** summary of the above, a bit cell (BC) may be provided, the BC including: a variable resistor and a first transistor connected in series between two end nodes; and a second transistor also connected between the two end nodes. Gates of the first and second transistors are connected to first and second word lines (WLs), respectively, for a row. Furthermore, a circuit is provided, the circuit including an array of BCs, wherein BCs are connected in a stack between a sense amplifier (SA) and footer device (FD) in each column. During a read operation, FDs connect the stacks to ground. Additionally, first and second WL voltages on first and second WLs for each row are such that, for any selected row, first transistors of BCs are on and second transistors are off and, for any unselected row, first transistors of BCs are off and second transistors are on. SAs compare sense currents from the stacks to a mid-level reference current to concurrently compute majority functions.

## Claims

1. A bit cell comprising:
a variable resistor and a first transistor connected in series between a first end node and a second end node, wherein a first gate of the first transistor is connected to a first word line; and
a second transistor connected between the first end node and the second end node, wherein a second gate of the second transistor is connected to a second word line.

2. The bit cell of claim 1, wherein the variable resistor is any of a resistive random access memory-type variable resistor, a magnetic tunnel junction-type variable resistor, and a phase change memory-type variable resistor, and/or wherein the first transistor, the second transistor, the third transistor and the fourth transistor are N-type field effect transistors

3. The bit cell of claim 1 or 2, further including:
a third transistor connected between the first end node and a source line, wherein a third gate of the third transistor is connected to a third word line; and
a fourth transistor connected between the second end node and a bit line, wherein a fourth gate of the fourth transistor is connected to a fourth word line.

4. The bit cell of one of claims 1 to 3,
wherein a resistance state of the variable resistor is switchable between at least a high resistance state and a low resistance state that is lower than the high resistance state depending on word line voltage levels on the first word line, the second word line, the third word line, the fourth word line, the source line, and the bit line, and
wherein the high resistance state is indicative of a first bit value stored in the variable resistor and the second resistance state is indicative of a second bit value stored in the variable resistor.

5. The bit cell of claim 4, wherein, during a memory operation, the first word line is connected to receive a first word line voltage and the second word line is connected to receive a second word line voltage that is inverted relative to the first word line voltage causing one of the first transistor and the second transistor is conductive.

6. The bit cell of claim 4 or 5, wherein the low resistance state is indicative of a "1" bit value stored in the variable resistor and the high resistance state is indicative of a "0" bit value stored in the variable resistor.

7. The bit cell of one of claims 4 to 6,
wherein the resistance state of the variable resistor is switchable between the high resistance state, the low resistance state, and a mid-level resistance state between the high resistance state and the low resistance state, and
wherein the bit cell is employable as a reference bit cell when the variable resistor has the mid-level resistance state.

8. An in-memory computing circuit comprising:
an array of bit cells in columns and rows;
first word lines for the rows, respectively; and
second word lines for the rows, respectively, wherein each bit cell is formed in accordance with the bit cell of each of claims 1 to 7 and, wherein, for each bit cell:
the first gate of the first transistor is connected to a first word line for a row; and
the second gate of the second transistor is connected to a second word line for the row.

9. The in-memory computing circuit of claim 8,
wherein each bit cell further includes:
a third transistor connected between the first end node and a source line for the column, wherein a third gate of the third transistor is connected to a third word line for the row; and
a fourth transistor connected between the second end node and a bit line for the column, wherein a fourth gate of the fourth transistor is connected to a fourth word line for the row, and
wherein the in-memory computing circuit further includes:
sense amplifiers for the columns, respectively; and
footer devices for the columns, respectively, wherein the bit cells in each column are electrically connected in series between a sense amplifier and a footer device for the column.

10. The in-memory computing circuit of claim 8 or 9,
wherein a resistance state of the variable resistor is switchable between at least a high resistance state and a low resistance state that is lower than the high resistance state, and
wherein the high resistance state is indicative of a first bit value stored in the variable resistor and the second resistance state is indicative of a second bit value stored in the variable resistor.

11. The in-memory computing circuit of claim 10, wherein the low resistance state is indicative of a "1" bit value stored in the variable resistor and the high resistance state is indicative of a "0" bit value stored in the variable resistor.

12. The in-memory computing circuit of one of claims 8 to 11,
wherein, during a read operation to concurrently compute majority functions directed to stored bit values in selected rows of bit cell stacks of the columns:
first and second word lines for the selected rows receive first and second word line voltages to turn on all first transistors of all bit cells in the selected rows and turn off all second transistors of the bit cells in the selected rows,
first and second word lines for any unselected rows receive opposite first and second word line voltages to turn off all first transistors in all bit cells in the unselected rows and to turn on all second transistors of the bit cells in the unselected rows,
the footer devices receive a read enable signal to electrically connect the bit cell stacks of the columns to ground, and
each sense amplifier for each column compares a sense current from a bit cell stack of the column to a reference current and outputs a corresponding data output signal,
wherein the reference current is equal to an expected sense current level when one-half of the bit cells in the selected rows in the bit cell stack store the "1" bit value, and
wherein the corresponding data output signal indicates whether a majority of the bit cells in the bit cell stack store the "1" bit value,
wherein each sense amplifier for each column preferably includes a first input terminal connected to one end of the bit cell stack, a second input terminal connected to receive the reference voltage node, and a data output signal node.

13. The in-memory computing circuit of claim 12,
wherein the array further includes a reference column of reference bit cells, each reference bit cell including a reference resistor having a mid-level resistance state between a high resistance state and a low resistance state, and
wherein the reference bit cells in the reference column are electrically connected in series to form a reference bit cell stack between a reference signal generator and an additional footer device for the reference column,
wherein the reference resistor preferably has any one of a fixed resistance and a variable resistance.

14. The in-memory computing circuit of claim 13,
wherein each sense amplifier for each column includes:
a P-type field effect transistor and an N-type field effect transistor connected in series between a positive supply voltage rail and the bit cell stack for the column; and
a comparator having a non-inverting input connected to receive the reference voltage and an inverting input connected to an intermediate node at a junction between the P-type field effect transistor and the N-type field effect transistor,
wherein gates of the P-type field effect transistor and the N-type field effect transistor are connected to a reference signal output node of the reference signal generator and a bias voltage generator, respectively,
wherein the reference signal generator includes an additional P-type field effect transistor and an additional N-type field effect transistor connected in series between the positive supply voltage rail and the reference bit cell stack and further includes the reference signal output node at a junction between the additional P-type field effect transistor and the additional N-type field effect transistor, and
wherein gates of the additional P-type field effect transistor and the additional N-type field effect transistor are connected to the reference signal output node and the bias voltage generator, respectively.

15. An in-memory computing method comprising:
storing bit values in bit cells of an array of the bit cells arranged in columns and rows,
wherein each bit cell includes:
a variable resistor and a first transistor connected in series between a first end node and a second end node, wherein a first gate of the first transistor is connected to a first word line for a row; and
a second transistor connected between the first end node and the second end node, wherein a second gate of the second transistor is connected to a second word line for the row, and
wherein the bit cells in the columns are connected in series forming bit cell stacks; and
performing a read operation to concurrently compute majority functions directed to stored bit values in selected rows of the bit cell stacks.
